# EUROPEAN PATENT APPLICATION

(11) **EP 0 893 700 A1**
(43) Date of publication of application: **27.01.1999**
(21) Application number: 97830395.6
(22) Date of filing: 25.07.1997
(51) Int. Cl.: G01R 33/38, G01R 33/421, G01R 33/3875, G01R 33/381

(54) **Solenoidal resistive magnet for nuclear magnetic resonance imaging**

(71) Applicant: Atlas Investments Ltd., Niue (NZ)
(72) Inventor: Sotgiu, Antonello, Univ.Degli Studi Dell'aquila, Via Vetolo-Loc. Coppito 2 67100 L'Aquila (IT)
(74) Representative: Iannone, Carlo Luigi

(57) **Abstract**

The present invention relates to a solenoidal resistive magnet (1) for nuclear magnetic resonance imaging comprising a plurality of symmetric coil couples (6) wound about an inner support (5 and 9), each couple (6) being independently powered, a cooling circuit (11), an outer metallic structure (10) comprising two lateral plates (2), two lateral rings (3), an inner yoke (4), an inner cylinder (5 and 9) supporting the coils (6) providing the field gradients ∂B₂ / ∂x, ∂B_{z} /∂y and ∂B_{z} /∂z, wherein z is directed along the axis of the cylinder (5).

## Description

The present invention relates to a solenoidal resistive magnet for nuclear magnetic resonance imaging.

More particularly, the invention relates to a solenoidal resistive magnet of cylindrical symmetry for nuclear magnetic resonance imaging.

Solenoidal resistive magnets have been extensively used in whole body equipment.

These magnets are built on the principle that building of a coil on the surface of a cylinder with a surface current density that follows a cosine distribution will produce a uniform magnetic field in the whole volume of the sphere. To this end, it can be made reference to W. Franzen, Rev. Sci. Instrum. 33, 933, 1962; J. Everett, J.A. Osemeikhian, J. Sci. Instrum. 43, 470, 1963.

Flat coils of diameter "2a" and separation "a" usually named Helmholtz coils are a very crude approximation of a spherical magnet.

A more accurate implementation of this principle is obtained by two couples of coils in which spacing, diameter and thickness of the coils are evaluated in such a way to achieve a cancellation of high order terms in the power development of the field.

Use of an iron enclosure for these magnet would make it impossible an accurate calculation of the field due to the non linearity characteristic of iron permeability. Furthermore, the iron yoke for "whole body" magnets would have a very relevant weight, thus making their use expensive either for material costs and for assembly costs. For this reason the "whole body" magnets are usually built without iron yoke and generate a distribution of fringing field in a large region around the magnet such as to require specific shieldings to fulfil with the existing rules.

Another consequence of this construction is that, lacking a low resistance return, they require, for the same field produced, a higher current and therefore dissipate a higher amount of power. Furthermore, they require a power supply of very good short and long term stability.

In the open-coil air-cored structures of these magnet the magnetic field extends in all the directions for distances of the order of the linear dimensions of the magnet affecting the ancillary electronic apparatus and being affected by the presence of metal structures.

In view of the above, the Applicant has realised a magnet able to obviates the above mentioned drawbacks.

It is therefore specific object of the present invention a solenoidal resistive magnet for nuclear magnetic resonance imaging comprising a plurality of symmetric coil couples wound about an inner support, each couple being independently powered, a cooling circuit, an outer metallic structure comprising two lateral plates, two lateral rings, a yoke, an inner cylinder supporting the coils that provide the field gradients ∂B₂ / ∂x, ∂B_{z} /∂y and ∂B_{z} /∂z, wherein z is directed along the axis of the cylinder.

Preferably, according to the invention, said plurality of coil couples is comprised of four couples of coils, the single coil of each couple being electrically connected each other.

Coils will be preferably wound according to an orthocyclic technique, and in any case optimising the space factor of the winding.

Still according to the invention, the feeding of the single coil couple is obtained by programmable power supply with high nominal short term stability, namely 1 part per million, controlled by 20 bit digital - analog and analog - digital converters.

According to the invention, the assembly of the coil couples is supported by a copper cylinder, which also magnetically insulates the coil couples providing a stationary field with respect to the field gradient providing a variable field.

According to the invention, the coil couples are separated by aluminium discs supported by said copper cylinder.

According to the invention, the above mentioned coil couples are cooled by a water circulation cooling system.

Preferably, said cooling circuit is a closed circuit employing deionised water as coolant.

According to the invention, the iron cylinder comprising the yoke terminates at the two ends with two circular ring shaped plates, fixed to the cylindrical yoke and to the copper inner cylinder, and with two rings allowing the removal of the inner support of the field gradient.

Furthermore, according to the invention, said lateral plates are made up of high temperature thermally treated ARMCO steel, said lateral rings are made up of ARMCO steel and said yoke is made up of mild iron, having a thickness of about 1.6 cm.

Still according to the invention, said inner cylinder supporting the field gradients ∂B₂ / ∂x, ∂B_{z} /∂y and ∂B_{z} /∂z is preferably made up of plastic material.

Preferably, it is made up of three concentric layers obtained by a photographic process on a copper sheet sustained by a thick mylard film.

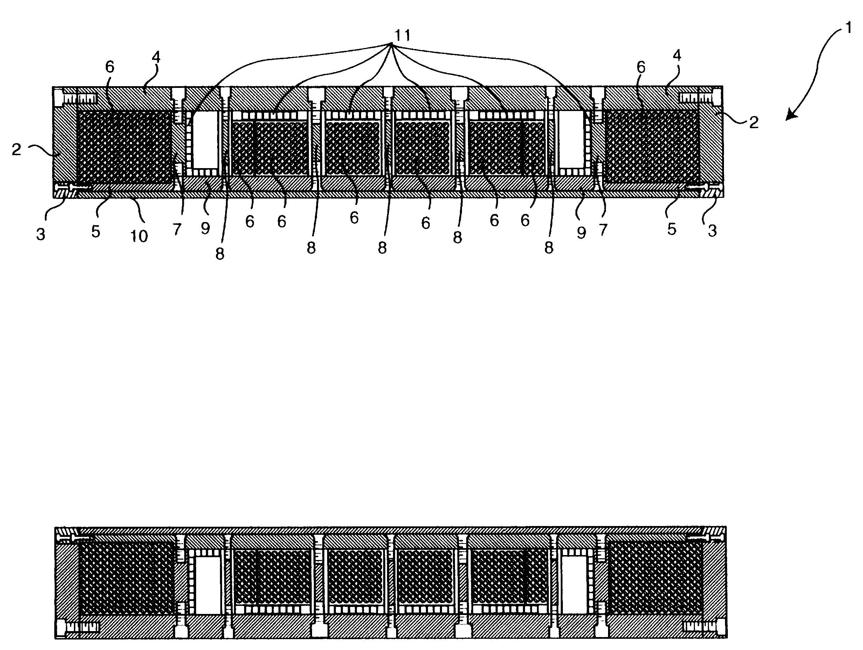

The present invention will be now described, for illustrative but not imitative purposes, according to one preferred embodiment, with particular reference to the figure of the enclosed drawings showing a schematic view of a solenoidal resistive magnet according to the invention.

As it can be seen from figure, the solenoidal resistive magnet 1 according to the invention provides two lateral plates 2, comprised of thermally treated ARMCO steel, to improve its magnetic properties, two lateral rings 3, comprised of thermally treated ARMCO steel, allowing to move in and out the field gradient assembly, and a mild iron cylindrical yoke 4.

By the reference number 5, a support cylinder is shown for the outer couple of coils 6, while reference number 7 indicates the support discs for the outer coils and reference number 8 indicates the support discs for the inner coils.

The copper cylinder 9 supporting the inner coils is integral with said cylinder 5.

Within the magnet, a plastic cylinder 10 supporting field gradients ∂B₂ / ∂x, ∂Bz /∂y and ∂B_{z} /∂z is provided.

By reference number 11, the cooling circuit is indicated.

As it can be noted, magnet 1 consists of three main parts, an iron enclosure (reference numbers 2, 3 and 4), the internal copper and aluminium structure (reference numbers 5 and 9) on which the coils 6 are wound and that is fixed to the iron enclosure, and the gradient cylinder 10 that is fixed to the iron enclosure 3.

The iron structure has both the mechanical function of supporting the whole structure and the electrical function of providing a low resistance path to the magnetic flux. At this purpose the most critical parts are the lateral plates that contribute to give the direction and intensity of the magnetic field at the two ends of the magnet.

The internal copper and aluminium structure consist of a cylindrical copper tube that is centred and secured at the two lateral plates 2, and has a thickness of 1 cm in the central region and reduces to 0.6 cm at the two ends in the region corresponding to the most outward coils 6 having bigger dimensions.

Seven aluminium disks 7 and 8 are fixed to the central copper tube and are fixed to the external iron cylinder 4. Said aluminium disks 7 and 8 limits the regions in which the coils 6 are winded. The whole central structure supports the windings 6 and the cooling circuit 11.

The coil assembly for the generation of field gradients is set in position after the assembling of the whole magnet 1 and is comprised of three concentric layers obtained by means of a photographic process on a copper sheet sustained by a thick mylard film. The whole coil assembly is comprised of three layers, 2 mm in thickness, and by three mylard layers 1 mm in thickness. This structure is bonded by a two component resin so as to obtain a very strong and stable construction.

Due to the presence of the iron yoke 4, the magnet 1 according to the invention is self shielding against the effect of other magnetic material in the vicinity of the apparatus.

Furthermore, the magnetic field is confined to a small distance from the bore of the magnet 1, the line corresponding to a field value of 0,5 mT being confined to a maximum distance of 30 cm from both ends of the magnet 1.

The magnetic field is generated by four couples of symmetric coils 6 wound on an internal copper support 5 and 9. To maximise the thermal conductivity and the space factor, the coils 6 are wound by an orthociclic techniques in which the turns of one layer of the coils are wound in the interstices of the preceding layer. As an alternative, sizes of the copper conductor are chosen in such a way to allow a minimum space factor of 0.8.

The current for each of the four pairs of symmetric coils 6 is provided by four remotely controlled power supply (not shown) of nominal short term stability of 1 part per million, controlled by a 20 bit digital - analog converter and a 20 bit analog to digital converter.

The cooling circuit cools the magnet 1 by a closed circuit of deionized water. The coolant water is then cooled in a refrigerating system or in a water/water heath exchanger without recover of the water.

The iron structure comprised of plates 2, rings 3 and cylindrical yoke 4 allows to confine the magnetic flux to avoid interference with any metal structure, to provide a low resistance path for the magnetic field, and to contribute to the reaching of a high value of the field homogeneity.

The lateral plates 2 are built by thermally treated mild iron.

To avoid the problems related to the hysteresis cycle of the material that can be present when switching on and off the magnet, a fifth power supply is employed, connected to the two larger coils 6, providing a 50 Hz amplitude controlled current, as used in demagnetisers, that permits to reduce virtually to zero the residual iron magnetisation. In this way, when switched on, the magnet moves always along the same magnetisation curve.

The positions, dimensions, intensities of the currents have been selected on the basis of simulations by standard programs of field computations. The tolerance of the mechanical construction and the approximations involved in the computation programs requires a subsequent shimming of the magnet. To obtain this shimming a computer controlled robot is used that moves the field sensor (an NMR or a Hall probe) inside the magnet volume. The reading of the probe is sent to a computer that evaluates the required current corrections and suitably drives the coil 6 power supply.

The shimming routine can be summarised as follows:
- it sets the current intensities obtained by the field simulation as initial values;
- for each point of a selected array of positions it reads the values of the field and of the field variations caused by a change of each of the four currents supplying the four coil couples;
- it compares the measured values with the required values and if the deviation is above a fixed value it calculates a new set of the current values;
- the procedure is repeated until the deviation computed is under the required value or until the program is unable to find a lower value of the deviation.

This procedure guarantees that the currents are chosen in such a way as to give the better uniformity that can be obtained with the construction tolerance of the individual magnet.

The use of four different power sources, high stability programmable power supply avoids the use of separate shimming coils.

The magnet 1 according to the invention generates the bias field required for nuclear magnetic resonance imaging.

The field is produced by the four couples of coils 6, whose current are controlled independently, and is directed along the axis of the coils 6.

Said coils 6 are surrounded by an iron shield that confines the magnetic field flux and reduces the power required to operate the magnet 1 according to the invention.

In the preferred embodiment of the magnet according to the invention, a homogeneity region is comprised of a cylinder having a diameter of 13 cm and a height of 13 cm.

The magnet 1 has an insertion bore of 23 cm and a total length of 44 cm.

The magnet 1 can be used for magnetic resonance imaging of extremities of human beings, for many kind of clinical exams on animals and in any case for all those imaging applications that can be done with a magnetic field of the order of 0.1 T.

The magnet 1 according to the invention can be switched off when not in use and requires about half an hour of waiting when switched on to achieve the required characteristics.

A suitably designed power off circuit avoids residual magnetisation of the iron sections reducing the problems related to histeresys in iron.

A thick copper screen confines the gradient coils from the magnet coils and allows an exact computation of the field gradient.

Due to the presence of this thick copper screen, the magnet 1 can be operated with pulsed field gradient or with modulated field gradient.

The present invention has been described for illustrative but not Imitative purposes, according to its preferred embodiments, but it is to be understood that modifications and/or changes can be introduced by those skilled in the art without departing from the relevant scope as defined in the enclosed claims.

## Claims

1. Solenoidal resistive magnet for nuclear magnetic resonance imaging characterised in that it comprises a plurality of symmetric coil couples wound about an inner support, each couple being independently powered, a cooling circuit, an outer metallic structure comprising two lateral plates, two lateral rings, a yoke, an inner cylinder supporting the coils providing the field gradients ∂B₂ / ∂x, ∂B_{z} /∂y and ∂B_{z} /∂z, wherein z is directed along the axis of the cylinder.

2. Magnet according to claim 1, characterised in that the single coil of each couple are electrically connected each other.

3. Magnet according to claim 1 or 2, characterised in that said plurality of coil couples is comprised of four couples of coils.

4. Magnet according to one of the preceding claims, characterised in that the feeding of the single coil couple is obtained by programmable power supply with high nominal short term stability, namely 1 part per million, controlled by a 20 bit digital - analog converter and a 20 bit analog - digital converter.

5. Magnet according to one of the preceding claims, characterised in that said coil couples are wound on a copper support element.

6. Magnet according to one of the preceding claims, characterised in that said coils are wound employing an orthocyclic technique.

7. Magnet according to one of the preceding claims, characterised in that the assembly of the coil couples is supported by a copper cylinder, which also magnetically insulates the coil couples providing a stationary field with respect to the field gradient providing a variable field.

8. Magnet according to one of the preceding claims, characterised in that the coil couples are separated by aluminium discs supported by said copper cylinder.

9. Magnet according to one of the preceding claims, characterised in that said lateral plates are made up of high temperature thermally treated ARMCO steel.

10. Magnet according to one of the preceding claims, characterised in that said lateral rings are made up of ARMCO steel.

11. Magnet according to one of the preceding claims, characterised in that said yoke is made up of mild iron

12. Magnet according to claim 11, characterised in that said yoke has a central thickness of about 1.6 cm.

13. Magnet according to one of the preceding claims, characterised in that said inner cylinder supporting the field gradients is made up of plastic material.

14. Magnet according to one of the preceding claims, characterised in that said inner cylinder is made up of three concentric layers obtained by a photographic process on a copper sheet sustained by a thick mylard film.

15. Magnet according to one of the preceding claims, characterised in that said cooling circuit is a closed circuit employing deionized water as coolant.
